(19) Europäisches Patentamt
European Patent Office
Office européen des brevets

(11) **EP 2 930 522 B1**

(12) **EUROPÄISCHE PATENTSCHRIFT**

(45) Veröffentlichungstag und Bekanntmachung des Hinweises auf die Patenterteilung:
**24.07.2019   Patentblatt 2019/30**

(51) Int Cl.:
**G01R 31/02** *(2006.01)*   **G01R 31/11** *(2006.01)*
**G01R 31/08** *(2006.01)*

(21) Anmeldenummer: **15163140.5**

(22) Anmeldetag: **10.04.2015**

(54) **VERFAHREN SOWIE VORRICHTUNG ZUR ORTSAUFGELÖSTEN DIAGNOSE**

METHOD AND DEVICE FOR SPATIALLY RESOLVED DIAGNOSIS

PROCÉDÉ ET DISPOSITIF DE DIAGNOSTIC À RÉSOLUTION SPATIALE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.04.2014   DE 102014005698**

(43) Veröffentlichungstag der Anmeldung:
**14.10.2015   Patentblatt 2015/42**

(73) Patentinhaber:
• **Seba-Dynatronic**
  **Mess- und Ortungstechnik GmbH**
  **96148 Baunach (DE)**
• **Friedrich-Alexander-Universität**
  **Erlangen-Nürnberg**
  **91054 Erlangen (DE)**

(72) Erfinder:
• **Weindl, Christian**
  **90513 Zirndorf (DE)**
• **Fischer, Erik**
  **90443 Nürnberg (DE)**

(74) Vertreter: **Marschall, Stefan**
  **Elbpatent**
  **Marschall & Partner PartGmbB**
  **Jessenstrasse 4**
  **22767 Hamburg (DE)**

(56) Entgegenhaltungen:
**EP-A2- 2 623 999     US-A- 4 538 103**
**US-A- 5 270 661**

• **KE LIU ET AL: "Network Cable Fault Location Based on the Wide Pulse Time Domain Reflection", TESTING AND DIAGNOSIS, 2009. ICTD 2009. IEEE CIRCUITS AND SYSTEMS INTERNATIONAL CONFERENCE ON, IEEE, PISCATAWAY, NJ, USA, 28. April 2009 (2009-04-28), Seiten 1-3, XP031460482, ISBN: 978-1-4244-2587-7**

EP 2 930 522 B1

**Beschreibung**

Die Erfindung betrifft zunächst ein Verfahren zur ortsaufgelösten Diagnose des elektrischen Zustands eines räumlich ausgedehnten Betriebsmittels, insbesondere eines Kabels zur Übertragung elektrischer Energie, mit Hilfe von Interferenz zwischen in das Betriebsmittel durch einen Signalgenerator eingespeisten Impulsen.

Darüber hinaus hat die Erfindung eine Vorrichtung zur ortsaufgelösten Diagnose eines elektrischen Zustands eines räumlich ausgedehnten Betriebsmittels, insbesondere eines Kabels zur Übertragung elektrischer Energie, mit Hilfe von Interferenz zwischen mindestens zwei um einen Impulsabstand $\Delta t$ zeitlich versetzt in das Betriebsmittel eingespeisten Impulsen.

Der aktuelle Stand der Technik im Bereich der Zustandsdiagnose von Energieversorgungskabeln beruht auf hergebrachten Verfahren, wie z. B. der Messung von Teilentladungen sowie einer Bestimmung des Verlustfaktors (s. g. tan($\delta$)-Messung).

Darüber hinaus sind weitere Verfahren, wie z. B. das Relaxationsstrommessverfahren sowie das Rückkehrspannungsmessverfahren bekannt. Bei diesen Messverfahren wird das zu untersuchende Kabel zunächst mit einer Gleichspannung polarisiert. Anschließend wird der Depolarisationsstrom bzw. die Rückkehrspannung nach einem Kurzschluss bestimmt. Mit diesen Messgrößen lässt sich wie im Fall der Verlustfaktorbestimmung der Zustand des Dielektrikums, wie z. B. der Feuchtegrad, der Isolationswiderstand etc., beurteilen. Es handelt sich jedoch um eine integrale Messmethode, die keine ortsaufgelöste Diagnose des Kabelzustands gestattet. Darüber hinaus sind diese Verfahren sehr empfindlich und störanfällig gegenüber äußeren Umgebungseinflüssen, wie z. B. Feuchtigkeit und Temperatur, sodass diese im Energieversorgungsbereich bislang nicht verbreitet wurde.

Bei der eingangs erwähnten Teilentladungsdiagnose (sogenannte "TE"-Diagnose (= Teilentladungs-Diagnose) werden Teilentladungsfehlstellen erkannt, bewertet und lokalisiert. Allein auf der Basis einer Teilentladungsdiagnose kann jedoch keine hinreichend verlässliche Aussage über den Kabelzustand bzw. dessen Restlebensdauer getroffen werden. Diese wird nur durch eine Kombination mit anderen Verfahren, wie z. B. der ein-gangs angesprochenen Verlustfaktormessung, möglich. Darüber hinaus ist es erforderlich, dass die Spannungsbelastung während der Messung größer ist als die Nennspannung, um überhaupt eine zuverlässige Zustandsprognose des Kabels zu erhalten. Aufgrund der hohen Spannungsbelastung kann jedoch eine zusätzliche Alterung bzw. Schädigung des zu diagnostizierenden Kabels hervorgerufen werden. Eine räumliche Lokalisierung einer Hauptentladungsstelle ist möglich, aber durch mehrfache Fehlstellen, hohe Kabellängen mit entsprechend starker Dämpfung oder Feuchtigkeit im Kabel, wird eine Lokalisierung deutlich erschwert.

Die Veröffentlichung "Network Cable Fault Location Based on the Wide Pulse Time Domain Reflection" von Ke Liu, Shulin Tian, Yindong Xiao und Di Xie (in: Testing and Diagnosis, 2009; ICDT 2009; IEEE Circuits and Systems International Conference ON, IEEE, Piscataway, NJ, USA (28. April 2009, Seiten 1 - 3); ISBN 978-1-4244-2587-7) offenbart ein auf Zeitbereichsreflektometrie beruhendes Vorgehen zum Auffinden von Kabelfehlern.

Aus der DE 10 2010 013 103 A1 ist eine Vorrichtung sowie ein Verfahren zur Diagnose von Messobjekten unter Verwendung einer Messspannung bekannt, wobei das Messverfahren im Wesentlichen auf der Verlustfaktorbestimmung beruht.

Die Messung erfolgt unter Verwendung von Hochspannung, die an das Kabel angelegt wird. Anschließend werden Messspannungen mittels einer Spannungserfassungseinrichtung und einzelnen Messobjekten zuzuordnenden Strömen mittels der wenigstens zwei Stromerfassungseinrichtungen gemessen und in einer Auswerteeinheit ausgewertet.

Die Erzeugung der notwendigen Messhochspannung kann z. B. mit einem großen Transformator erfolgen, was jedoch aufwändig und teuer ist. Alternativ kann die Messhochspannung über ein Resonanzsystem oder ein s. g. "VLF" -Verfahren (= Very Low Frequency-Verfahren) erfolgen, die aber nicht mit der üblichen Netzfrequenz von 50 Hz arbeiten. Darüber hinaus handelt es sich um eine integrale Messmethode, d. h. eine Ortsauflösung ist nicht möglich und es kann mithin nur der Gesamtzustand eines Kabels beurteilt werden.

Aus der JP 2001 153913 (A) ist ferner ein Diagnoseverfahren zur ortsaufgelösten Erfassung einer Verschlechterung bzw. Degeneration der elektrischen Eigenschaften eines Kabels bekannt.

Hierbei wird die Frequenzbereichs-Reflektometrie ("FDR-Verfahren" = Frequency Domain Reflectometry-Verfahren) genutzt, die teilweise auch zur Zustandsdiagnose herangezogen werden kann. Ein Vorteil dieser Messmethode liegt darin, dass sie zerstörungs- sowie nahezu belastungsfrei durchführbar ist und demzufolge nur einen vergleichsweise geringen apparativen Aufwand erfordert.

Verfahrensgemäß wird eine Resonanzstellen- bzw. Frequenzspektral-Analyse durchgeführt, wobei als Eingangssignal meist ein Frequenzdurchlauf verwendet wird. Es lassen sich somit Impedanz-Änderungen entlang eines Kabels ähnlich wie bei der Zeitbereichs-Reflektometrie ("TDR" = Time Domain Reflectometry) ermitteln.

Allerdings sind nur starke Änderungen der elektrischen Eigenschaften des Kabels detektierbar, wodurch sich der elektrische Zustand des Kabels bzw. des Dielektrikums nicht hinreichend aussagekräftig beurteilen lässt. Durch eine Vorpolarisierung des Prüflings durch eine hohe Gleichspannung können Fehlstellen unter Umständen besser hervorgehoben und durch eine anschließend durchgeführte TDR-Messung oder FDR-Messung überhaupt erst erkannt werden.

Aus der US 7, 966, 137 B2 ist ferner ein Analyseverfahren bzw. -system auf der Grundlage von Resonanzmessungen an Leitungen bekannt (Leitungsresonanzanalyse).

Hierbei handelt es sich im Prinzip um ein FDR-Messverfahren mit einer Resonanzstellen-Analyse. Diese Frequenzspektral-Analyse liefert jedoch kaum zuverlässige Informationen über den Zustand des Kabels, sofern keine (Referenz-)Messungen an einem identischen, intakten Kabel vorliegen.

Aus der US 2006/0097730 A1 ist weiterhin eine Vorrichtung sowie ein Verfahren zur Durchführung von TDR-Reflexionsmessungen bekannt.

Hierbei kommt das s. g. JTFDR-Messverfahren (JTFDR = "Joint Time Frequency Domain Reflectometry") zum Einsatz, das eine Kombination aus dem TDR-Messverfahren und dem FDR-Messverfahren darstellt. Hierbei wird ein angepasstes Eingangssignal in der Form eines Frequenzdurchlaufs mit einem Gauß-Impuls als Hüllkurve in das zu untersuchende Kabel eingespeist und die Eigenschaften von beiden Verfahren vereint.

Ein Nachteil dieses vorbekannten Verfahrens ist darin zu sehen, dass wiederum nur Änderungen der Impedanz bzw. des Frequenzspektrums detektierbar und auswertbar sind.

Die US 2008/0048668 A1 offenbart darüber hinaus Diagnoseverfahren für elektrische Kabel unter Verwendung einer Axialtomographie.

Hierbei wird das zu untersuchende Kabel am Anfang und am Ende in geeigneter Weise beschaltet, was z. B. durch eine variable Spannung, einen Innenwiderstand, eine variable Frequenz, eine Lastimpedanz oder dergleichen erfolgen kann, und so eine stehende Welle erzeugt. Mit Hilfe der Spannungs- und Stromverteilungen und einer Messung der Scheinleistung am Ein- und Ausgang des Kabels können Bilanzgleichungen aufgestellt werden, die durch N-malige Variation der Eingangsparameter ein Gleichungssystem ergeben, durch das sämtliche Leitungsparameter an einem beliebigen Punkt des Kabels theoretisch bestimmbar werden.

Dieses Verfahren impliziert jedoch einen immens hohen Messaufwand an beiden Seiten des zu untersuchenden Kabels, da eine Vielzahl von Messungen mit verschiedensten Eingangsparametern durchgeführt werden müssen, um ein Ergebnis zu erhalten.

Eine Aufgabe der Erfindung ist es daher, ein Verfahren zur ortsaufgelösten elektrischen Diagnose eines räumlich ausgedehnten Betriebsmittels, insbesondere eines Hochspannungskabels zur Energieübertragung anzugeben. Darüber hinaus ist eine Aufgabe der Erfindung eine mobile und zugleich einfach zu handhabende Vorrichtung zur Durchführung des Verfahrens anzugeben.

Diese Aufgabe wird zunächst durch ein Verfahren nach Maßgabe des Patentanspruchs 1 mit den folgenden Schritten gelöst:

a) Einspeisen von mindestens zwei um einem Impulsabstand Δt versetzten Impulsen in das Betriebsmittel,
b) Erfassen der interferierten Impulse und Echos mittels einer Auswerteeinheit,
c) Variation des Impulsabstandes Δt zur ortsaufgelösten Abtastung des Betriebsmittels entlang dessen Länge 1,
d) wiederholen der Schritte a) bis c) bis das Betriebsmittel zumindest abschnittsweise abgetastet ist, und
e) Auswerten der erfassten interferierten Impulse in der Auswerteeinheit.

Hierdurch ist eine präzise, ortsaufgelöste Diagnose des elektrischen Zustands eines räumlich vorrangig in seiner Längsrichtung ausgedehnten Betriebsmittels, insbesondere eines Kabels zur Energieversorgung, einschließlich etwaiger Kopplungselemente, wie z. B. Kabelmuffen, möglich. Das Verfahren ermöglicht hinreichend belastbare Aussagen über lokale qualitative Eigenschaften, so dass mit zusätzlichem Expertenwissen die Ausfallwahrscheinlichkeit exakt definierter Kabelsegmente bzw. Kabelabschnitte prognostiziert werden kann. Aufgrund des vergleichsweise geringen Messaufwands kann das Verfahren auch für Kabelmessungen im Feld, d. h. vor Ort, eingesetzt werden. Die Form der Impulse kann grundsätzlich einen beliebigen zeitlichen Verlauf aufweisen.

Im Fall einer günstigen Ausgestaltung werden im Verfahrensschritt e) zur ortsaufgelösten Diagnose lokale Energieverluste eW(x) über die Länge 1 des Kabels hinweg anhand einer Vielzahl von durch die Impulse hervorgerufenen Interferenzspannungsverläufen und Spannungsverläufen rechnerisch ermittelt, wobei die Spannungsverläufe mittels der Auswerteeinheit digitalisiert und rechnerisch zu einer fehlerfreien Nachbildung des Betriebsmittels in Beziehung gesetzt werden.

Hierdurch lassen sich verlässliche, ortsaufgelöste Aussagen über den elektrischen Zustand des Betriebsmittels treffen. Zusätzlich können interferenzfreie Spannungsverläufe zu den Interferenzspannungsverläufen in Beziehung gesetzt werden, um die Auswertung zu optimieren. Infolge der digitalen Auswerteeinheit ist eine Erfassung und rechnerische Auswertung der vom Analog-Digitalwandler aufgenommenen Spannungsverläufe in Echtzeit möglich.

Bei einer weiteren vorteilhaften Ausgestaltung des Verfahrens interferieren jeweils zwei Impulse gleicher oder gegensätzlicher Polarität konstruktiv oder destruktiv miteinander.

Hierdurch kann im Rahmen des erfindungsgemäßen Messverfahrens sowohl die konstruktive Interferenz zwischen den in das Kabel eingespeisten Impulspaaren und/oder auch deren destruktive Interferenz ausgenutzt werden.

Nach Maßgabe einer günstigen Weiterentwicklung werden Impulse und Impulsfolgen mit einer Maximalamplitude von bis zu 1.000 Volt erzeugt.

Hierdurch ist eine schonende Prüfung des Betriebsmittels ohne die Gefahr einer Vergrößerung bereits etwaig bestehender dielektrischer Vorschäden möglich. Die eingesetzten Impulse können z. B. eine rechteckförmige, trapezförmige, dreieckförmige, sägezahnförmige, sinusförmige, sin(x)/x-förmige, exponentielle, halbkreisförmige, halbelliptische, gefenstert rechteckförmige, glockenförmige (Gauß-förmige) Impulsform oder eine beliebige Kombination von mindestens zwei der genannten Impulsformen aufweisen. Die gefensterten Rechteckimpulse können z. B. nach Art von "Hamming", "Blackmann", "Harris", "Kaiser" oder "von Hann" ausgebildet sein.

Durch eine geeignete Wahl der Impulsform (z. B. Gauß-Impuls etc.) der in das Betriebsmittel eingespeisten Impulse werden die Diagnosemöglichkeiten des erfindungsgemäßen Messverfahrens optimiert. Durch die geeignete Wahl der Impulsform kann ferner eine Dispersionskorrektur erfolgen. Zu diesem Zweck kann man z. B. Impulse erzeugen, die in einem interessierenden, insbesondere zu untersuchenden Abschnitt des ausgedehnten Betriebsmittels bzw. des Kabels rechteckförmig sind, aber an dessen Anfang gerade nicht.

Nach Maßgabe einer weiteren günstigen Ausgestaltung wird die Länge 1 des Betriebsmittels mittels der digitalen Auswerteeinheit und des Signalgenerators, insbesondere mit Hilfe einer Laufzeitmessung mindestens eines Impulses, erfasst.

Hierdurch ist eine einfache Bestimmung der Länge 1 des zu diagnostizierenden Betriebsmittels möglich. Die Kenntnis der genauen Länge 1 ist unter anderem notwendig, um den Impulsabstand $\Delta t$ der in das Kabel eingespeisten Impulse so zu beeinflussen, dass diese an einer zu untersuchenden Stelle x miteinander interferieren bzw. überhaupt eine Interferenz erfolgt. Durch die sukzessive Variation des Impulsabstandes $\Delta t$ der in das Kabel eingespeisten Impulspaare kann das Kabel über seine Gesamtlänge 1 präzise abgetastet und elektrisch evaluiert werden. Alternativ kann die Ermittlung der Gesamtlänge des Betriebsmittels auch mittels bekannter TDR-Verfahren, FDR-Verfahren oder einer Kombination hiervon erfolgen.

Bei einer weiteren günstigen Fortbildung des Verfahrens ist vorgesehen, dass die ortsaufgelöste Diagnose des elektrischen Zustands des Kabels vollautomatisch unter bevorzugter Kontrolle der digitalen Auswerteeinheit und/oder manuell erfolgt.

Hierdurch ist ein problemloser und weitgehend von Messfehlern freier Einsatz des erfindungsgemäßen Messverfahrens zur Kabeldiagnose gegeben. Ergänzend oder alternativ ist eine manuelle Ablaufsteuerung des Verfahrens möglich.

Darüber hinaus wird die erfindungsgemäße Aufgabe durch eine Vorrichtung nach Maßgabe von Patentanspruch 7 gelöst.

Dadurch, dass mindestens ein Signalgenerator zur Erzeugung der Impulse mit dem Betriebsmittel und mit einer Auswerteeinheit verbunden ist, wobei zur ortsaufgelösten Diagnose lokale Energieverluste eW(x) über die Länge 1 des Betriebsmittels hinweg anhand einer Vielzahl von durch die Impulse hervorgerufenen Interferenzspannungsverläufen und Spannungsverläufen rechnerisch ermittelbar sind, ist eine genaue, ortsaufgelöste Diagnose des elektrischen Zustands eines ausgedehnten Betriebsmittels, insbesondere dessen Dielektrikums, über seine Gesamtlänge 1 hinweg mit einem vergleichsweise geringen Messaufwand möglich. Dies gestattet verlässliche Aussagen über den elektrischen Zustand von einzelnen Abschnitten des primär in seiner Längsrichtung ausgedehnten Betriebsmittels unter Einbeziehung von etwaig vorhandenen Verbindungselementen, wie zum Beispiel Kabelmuffen oder dergleichen.

Durch die geeignete Wahl der Impulsform (z. B. Gauß-Impuls) der mittels des Signal- bzw. des Impulsgenerators erzeugten und in das Betriebsmittel eingespeisten Impulse werden die Diagnosemöglichkeiten des erfindungsgemäßen Messverfahrens erheblich erweitert. Die Form der Impulse kann hierbei einen beliebigen zeitlichen Verlauf aufweisen und z. B. rechteckförmig, trapezförmig, dreieckförmig, sinusförmig, glockenförmig (Gauß-förmig) oder mit einer Überlagerung derartiger Geometrien gebildet sein. Ergänzend oder alternativ können die Impulse auch durch das abschnittsweise Zusammensetzen unterschiedlicher Geometrien gebildet sein. Die Impulse können z. B. in Bezug zu ihrer Mitte (tW/2) asymmetrisch sein. Durch die Pulsform erfolgt zudem die Dispersionskorrektur. Zu diesem Zweck erzeugt der Signalgenerator Impulse, die in einem interessierenden, insbesondere in dem zu untersuchenden Abschnitt des ausgedehnten Betriebsmittels bzw. des Kabels rechteckförmig sind, aber an dessen Anfang eine hiervon abweichende Verlaufsform aufweisen. Das geht nur eingeschränkt, weil die sich überlagernden Pulse unterschiedliche Lauflängen haben.

Nach Maßgabe einer günstigen Ausgestaltung sind die Spannungsverläufe mittels der Auswerteeinheit digitalisierbar und rechnerisch zu einer fehlerfreien Nachbildung des Betriebsmittels in Beziehung setzbar.

Hierdurch lassen sich fehlerhafte Abschnitte des Betriebsmittels zuverlässig und in der Regel rechtzeitig vor einem elektrischen Totalversagen erkennen.

Bei einer vorteilhaften Weiterbildung sind dem Signalgenerator ein Filtersystem und eine variable Impedanz nachgeschaltet, wobei die anpassbare Impedanz mit einem Anfang des Betriebsmittels verbunden ist.

Hierdurch ist eine messtechnisch optimale Ankopplung an das Betriebsmittel bzw. das Energiekabel gegeben.

Gemäß einer Ausgestaltung ist der Auswerteeinheit eine Messeinrichtung, insbesondere ein Analog-Digitalwandler, und mindestens eine digitale Recheneinheit, zugeordnet.

Hierdurch können die Spannungsverläufe und ihre Echos mit hoher Genauigkeit in Echtzeit erfasst und ausgewertet werden. Vorzugsweise ist mindestens ein Bildschirm als eine optische Ausgabeeinheit vorgesehen. Ferner kann die Auswerteeinheit auch einen Drucker aufweisen. Darüber hinaus kann der Auswerteeinheit auch eine akustische Signaleinrichtung, wie z. B. ein Lautsprecher zur Ausgabe von Signaltönen und/oder von Pieptönen für bestimmte Betriebszustände oder Fehlermeldungen und/oder eine Sprachausgabe zugeordnet sein.

Nach Maßgabe einer Ausgestaltung der Vorrichtung ist ein Ende des Betriebsmittels offen oder mit einer Impedanz Z abgeschlossen.

Hierdurch lässt sich die Interferenz der in das Betriebsmittel eingespeisten Impulse beeinflussen.

Weiterhin ist vorgesehen, dass die fehlerfreie Nachbildung des Betriebsmittels mit dem Signalgenerator und der Auswerteeinheit koppelbar ist.

Hierdurch sind Referenzmessungen und Auswertungen mit einem identischen, jedoch zweifelsfrei intakten Betriebsmittel bzw. Kabel möglich, wobei die Nachbildung bevorzugt mittels einer digitalen Simulation innerhalb der Auswerteeinheit realisiert ist.

Bei einer weiteren günstigen Fortbildung ist vorgesehen, dass mittels des Signalgenerators Impulse gleicher Polarität oder Impulse mit gegensätzlicher Polarität erzeugbar sind.

Hierdurch können die in das Betriebsmittel eingespeisten Impulse im Wege konstruktiver oder destruktiver Interferenz miteinander wechselwirken.

Gemäß einer vorteilhaften Ausgestaltung ist eine Länge 1 des Betriebsmittels mittels der Auswerteeinheit und des Signalgenerators, insbesondere mit Hilfe einer Laufzeitmessung mit mindestens einem Impuls erfassbar.

Hierdurch ist eine besonders einfache Erfassung der Gesamtlänge 1 des zu diagnostizierenden Kabels bzw. Betriebsmittels möglich.

In der Zeichnung zeigt:

Fig. 1 Energieverlust bei Interferenz der Impulspaare in einem veränderten Bereich eines vorrangig in seiner Längsrichtung ausgedehnten Betriebsmittels,

Fig. 2 Energieverlust bei Interferenz der Impulspaare in einem homogenen (intakten) Bereich des Betriebsmittels,

Fig. 3 Energieverlust bei fehlender Interferenz der Impulspaare in dem Betriebsmittel,

Fig. 4 Spannungsverlauf bei konstruktiver Interferenz der Impulspaare,

Fig. 5 Stromverlauf bei konstruktiver Interferenz der Impulspaare,

Fig. 6 Spannungsverlauf bei destruktiver Interferenz der Impulspaare,

Fig. 7 Stromverlauf bei destruktiver Interferenz der Im pulspaare,

Fig. 8 dielektrische Energieverluste bei konstruktiver und destruktiver Interferenz des Kabels mit einem defekten Bereich bei ca. 30 % einer (Gesamt-)länge 1 des Betriebsmittels,

Fig. 9 elektrisches Blockschaltbild einer Ausführungsform einer erfindungsgemäßen Vorrichtung zur Durchführung des Verfahrens,

Fig. 10 einen Spannungsverlauf UA(t) an einem Anfang des Betriebsmittels,

Fig. 11 den Spannungsverlauf UA(t) am Anfang des Betriebsmittels ohne Reflexionen, und

Fig. 12 den Spannungsverlauf UA(t) am Anfang des Betriebsmittels mit Reflexionen.

vorab sollen kurz die theoretischen Grundlagen des erfindungsgemäßen Verfahrens erläutert werden. Das Verfahren nutzt die Interferenzeigenschaften von elektrischen Wanderwellen aus, um eine ortsaufgelöste Diagnose von einem räumlich vorrangig in seiner Längsrichtung ausgedehnten Betriebsmittel, insbesondere einem Kabel zur Energieübertragung, zu ermöglichen und die Eigenschaften des Dielektrikums mit hoher Genauigkeit qualitativ zu beschreiben.

Unter dem Terminus eines "räumlich in seiner Längsrichtung ausgedehnten Betriebsmittels" werden im Kontext dieser Beschreibung hauptsächlich ein- oder mehradrige Energieversorgungskabel aller Spannungsebenen, unter Einschluss etwaig notwendiger Kopplungs- und Anbindungselemente, wie z. B. Muffen und dergleichen, verstanden.

Im Zuge des erfindungsgemäßen Verfahrens wird eine Vielzahl von wanderwellen bildenden Impulspaaren in das zu untersuchende Betriebsmittel bzw. das Kabel eingespeist. Die die Wanderwellen hervorrufenden Impulse breiten sich in dem zu untersuchenden Betriebsmittel mit einer endlichen Geschwindigkeit v aus und werden durch leitungsbedingte Verluste gedämpft und verzerrt.

Dieses Verhalten wird mit der komplexen Fortpflanzungskonstante $\gamma$ berücksichtigt. Sie setzt sich aus einem reellen $\alpha$ und einem imaginären Anteil $\beta$ zusammen. Der Realteil $\alpha$ der Fortpflanzungskonstante wird als Dämpfungskonstante und der Imaginärteil $\beta$ als Phasenkonstante bezeichnet.

$$\gamma = \alpha + j\beta = \sqrt{(R' + j\omega L') \cdot (G' + j\omega C')} \tag{1}$$

Geht man von einer hier zulässigen Vereinfachung für Wanderwellen aus, berechnet sich die Ausbreitungs- bzw. Fortpflanzungsgeschwindigkeit aus dem Induktivitäts- und dem Kapazitätsbelag des Mediums wie folgt:

$$v = \frac{\partial x}{\partial t} = \frac{1}{\sqrt{L'C'}} \tag{2}$$

Treten im Kabel Dämpfung und Dispersion auf, so unterscheidet man noch eine Gruppen- und Phasengeschwindigkeit, bei denen ein Widerstands- und ein Leitwertbelag berücksichtigt werden müssen. Eine Wanderwelle besteht in diesem Fall aus einem zeitdiskreten Signal, das als ein Impuls mit einer definierten Amplitude, Impulsbreite tW und -form interpretiert wird. Diese Größen sind variabel und abhängig vom zu diagnostizierenden Kabel. Gemessen wird der Spannungs- bzw. Stromverlauf am Eingang bzw. Ausgang des Kabels. Dieses Vorgehen ähnelt zunächst der Zeitbereichs-Reflektometrie bzw. Time-Domain-Reflectometry (TDR).

Im Unterschied dazu wird beim erfindungsgemäßen Verfahren nicht ein einzelner Impuls oder Sprung erzeugt, sondern immer ein Impulspaar mit einem definierten Impulsabstand $\Delta t$. Diese Impulse werden von einer bzw. von beiden Seiten aus eingespeist. In beiden Fällen sollen sich die Impulspaare an einer konkreten Stelle x, die sich aus dem vorher definierten Impulsabstand ergibt, im Ausbreitungsmedium treffen. Hierbei gilt: $0 \leq x \leq 1$, wobei 1 die Gesamtlänge des zu untersuchenden des Betriebsmittels ist. Betrachtet man zunächst die einseitige Speisung, kann dies dadurch erreicht werden, dass am Leitungsanfang ein Impulspaar eingespeist wird und das Leitungsende "offen" ist. Somit ergibt sich am Ende eine Reflexion der Wanderwellen bzw. des Impulspaares - wobei der Reflexionsfaktor der Spannung am offenen Kabelende Eins ist - und es entsteht eine zurücklaufende Welle. Die zurücklaufende Wanderwelle bzw. der erste Impuls und die zweite noch nachlaufende Welle bzw. der zweite Impuls treffen sich in dem Betriebsmittel bzw. dem Kabel an der Stelle x, die abhängig ist vom Impulsabstand und der Ausbreitungsgeschwindigkeit. Eine weitere Variante ist die Terminierung des Kabels mit einer variablen Impedanz Zk+1, wodurch sich andere Reflexionsfaktoren ergeben.

$$r_k = \frac{Z_{k+1} - Z_k}{Z_{k+1} + Z_k} \tag{3}$$

Am Ende des Betriebsmittels, wenn $Z_{k+1} \rightarrow \infty$ gilt:

$$r_k = \lim_{Z_{k+1} \rightarrow \infty} \frac{Z_{k+1} - Z_k}{Z_{k+1} + Z_k} = 1 \tag{4}$$

An der Stelle, an der sich die Impulse treffen bzw. überlagern, tritt Interferenz auf und es entstehen dort lokal erhöhte bzw. erniedrigte elektrische Verluste im Vergleich zu den restlichen Abschnitten innerhalb des Dielektrikums des zu untersuchenden Betriebsmittels. Dadurch wird eine wirkliche Ortsauflösung im Zuge des erfindungsgemäßen Verfahrens möglich. Der Wellenwiderstand des Betriebsmittels ergibt sich hierbei wie folgt:

$$\underline{Z} = \sqrt{\frac{R'+j\omega L'}{G'+j\omega C'}} = \frac{u_h(x,t)}{i_h(x,t)} = \frac{u_r(x,t)}{i_r(x,t)} \qquad (5)$$

Vereinfachte Formel des Wellenwiderstands nach der Wellentheorie mit reellen Größen:

$$Z_w = \sqrt{\frac{L'}{C'}} \qquad (6)$$

Weiterhin gilt die allgemeine Formel des Energieverlustes:

$$E_V = \int_{t_0}^{t_1} u(t) \cdot i(t) dt = \int_{t_0}^{t_1} P_V(t) dt \qquad (7)$$

Die Verlustleistung in einem diskreten Element (Abschnitt) des zu untersuchenden Betriebsmittels folgt der Beziehung:

$$P_V = \frac{U^2}{\dfrac{R'}{Z_w^2}+G'} \qquad (8)$$

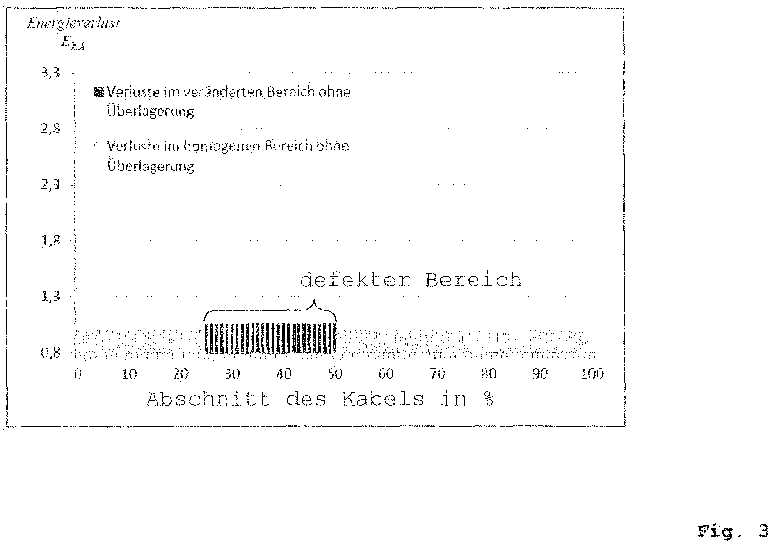

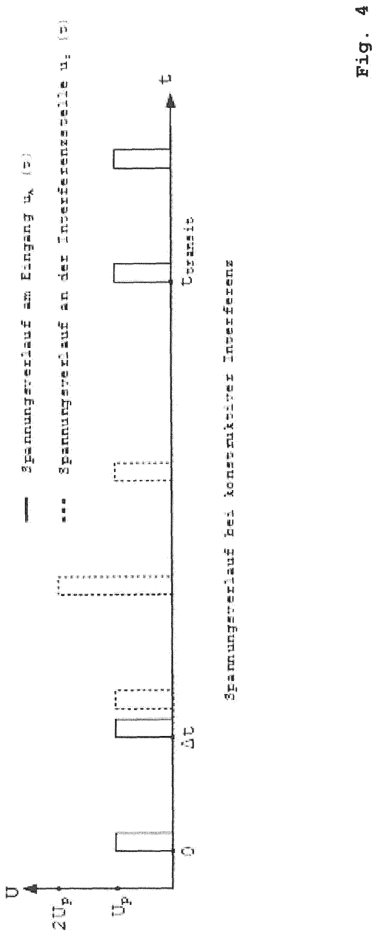

So entstehen an der Interferenzstelle x deutlich erhöhte elektrische Verluste, die direkt an der Stoßstelle maximal sind und zum Rand hin abnehmen. Vernachlässigt man die Dämpfung auf der Leitung, ergibt sich gemäß Gleichung (7) eine Verteilung der Verluste in Form eines Dreiecks, wie sie auch in den Fig. 3 und Fig. 4 illustriert ist.

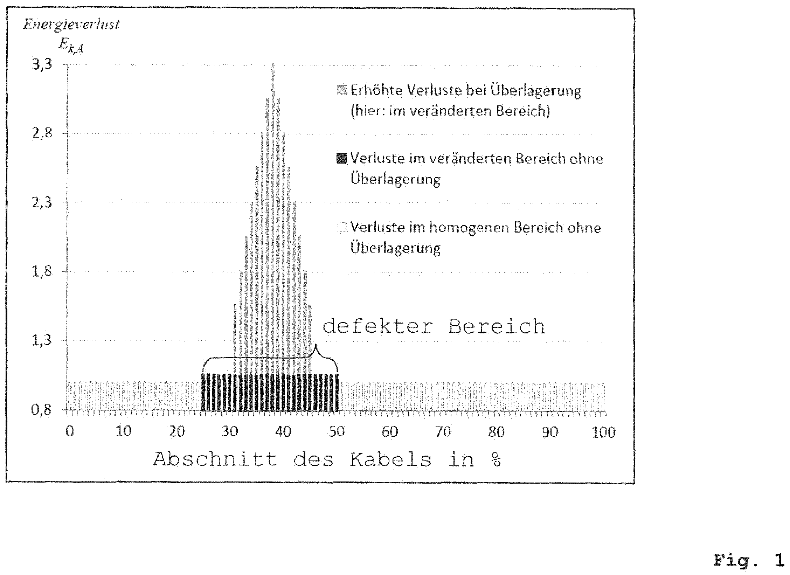

In den Fig. 1 bis 3 sind verschiedene Energieverluste innerhalb eines mittels des Verfahrens zu diagnostizierenden Betriebsmittels dargestellt, welches in einem Bereich veränderte dielektrische Eigenschaften aufweist.

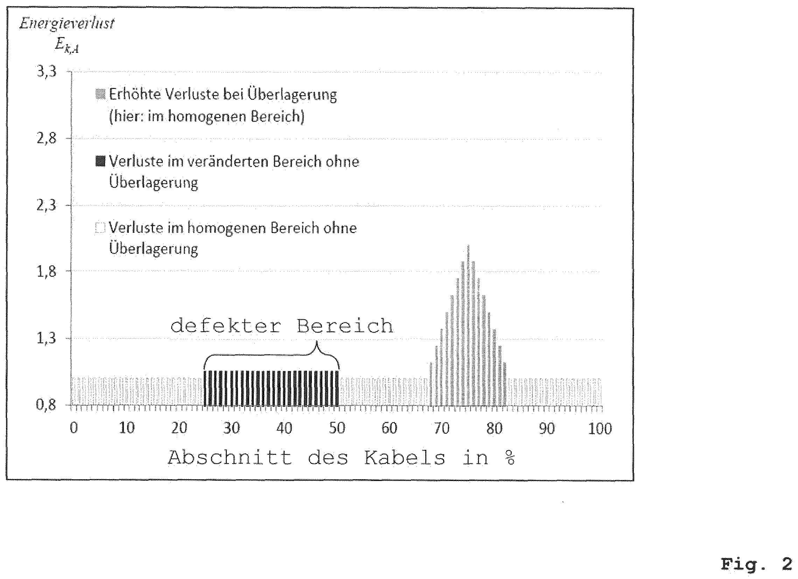

In dem Diagramm von Fig. 1 treffen sich die Impulse genau in diesem veränderten Bereich und verursachen dort deutlich erhöhte Verluste. In der Fig. 2 findet eine Überlagerung der Impulse im unveränderten (intakten) Bereich des Kabels statt und in der Fig. 3 ist der Impulsabstand so groß gewählt, dass keine Überlagerung stattfindet, so dass sich die Impulse überhaupt nicht mehr treffen bzw. miteinander wechselwirken und demzufolge auch keine Interferenz auftritt.

Betrachtet man weiterhin den idealen, ungedämpften Fall, lassen sich diese Energieverläufe mit den Spannungs- bzw. Stromverläufen am Eingang und an der Interferenzstelle im Kabel, wie in Fig. 4 bis 7 gezeigt, begründen.

Es kommt an dem Treffpunkt der beiden in das Betriebsmittel eingespeisten Impulse bzw. im Interferenzpunkt der Impulse - wie mit einer gestrichelten Linie angedeutet - zu einer Spannungsverdopplung bzw. zu einem vollständigen Auslöschen des Stromes. Diese Spannungsverdopplung wirkt an der Stoßstelle der Impulse am längsten ein und erzeugt somit dort auch die größten dielektrischen Verluste. Diese lokal erzeugten Verluste stellen die Diagnosegrundlage des erfindungsgemäßen Verfahrens dar. Daraus lassen sich an jeder zu untersuchenden Stelle x des Betriebsmittels die relevanten Kenngrößen des Dielektrikums präzise ermitteln und bewerten.

Um die dielektrischen Eigenschaften in Abhängigkeit des Ortes zu ermitteln, muss mit Hilfe des erfindungsgemäßen Verfahrens das zu untersuchende Medium über seine Gesamtlänge 1 hinweg abgetastet werden. Dies geschieht durch Veränderung des Impulsabstandes Δt der beiden eingespeisten Impulse bzw. des Impulspaares.

Zunächst muss die Gesamtlaufzeit tTransit bzw. tDurchlauf der Impulse durch das Betriebsmittel, die jeweils abhängig von der Ausbreitungsgeschwindigkeit und Länge des Betriebsmittels ist, bestimmt werden. Dieses kann beispielsweise mit Hilfe einer Reflexionsmessung im Zeitbereich oder im Frequenzbereich, d. h. mittels einer hergebrachten TDR-Messung bzw. FDR-Messung erfolgen. Unabhängig von dem angewendeten Messverfahren zur Bestimmung aller relevanten elektrischen Leitungsparameter ist der kleinste Impulsabstand ΔtMim stets abhängig von der Impulsbreite tW und muss hierbei immer größer oder gleich der Impulsbreite tW sein. Die Anzahl der zeitlich auflösbaren Schritte zwischen ΔtMin und ΔtMax ergibt die minimale Schrittweite (Auflösung) der Abtastung in axialer Richtung des Betriebsmittels. Durch die Impulsbreite tW ist ferner die reale Breite der Interferenzzone der beiden Impulse, die Ausbreitungsgeschwindigkeit sowie die Überlappungszeit der Impulse beeinflussbar.

Der Impulsabstand Δt bei Interferenz an einer zu untersuchenden Stelle x, bei einer Gesamtlänge 1 des Kabels und einer Ausbreitungsgeschwindigkeit v der Impulse, lässt sich allgemein wie folgt berechnen:

$$\Delta t = t_1 - t_2 = \frac{2l - x}{v} - \frac{x}{v} \qquad (9)$$

Somit ergibt sich der größtmögliche Impulsabstand ΔtMax wie folgt:

$$v = \frac{2l}{t_{Transit}} \Rightarrow \Delta t_{Max} = \frac{2l}{v} \qquad (10)$$

Als Ergebnis erhält man einen Ortsverlauf der lokal erzeugten elektrischen Verluste in Abhängigkeit der Messgrößen, was die Diagnosegrundlage für eine Bewertung der Einzelsegmente mittels des erfindungsgemäßen Verfahrens bildet. Für die Auswertung der Messergebnisse existiert eine Vielzahl von Möglichkeiten, wie z. B. die Bewertung des ortsabhängigen Zustands über den Energieverlust an der jeweiligen Stelle.

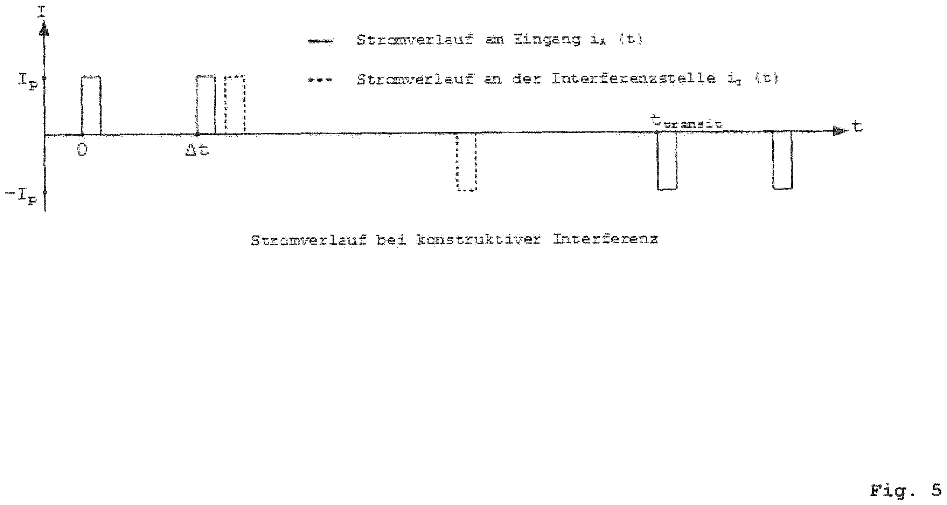

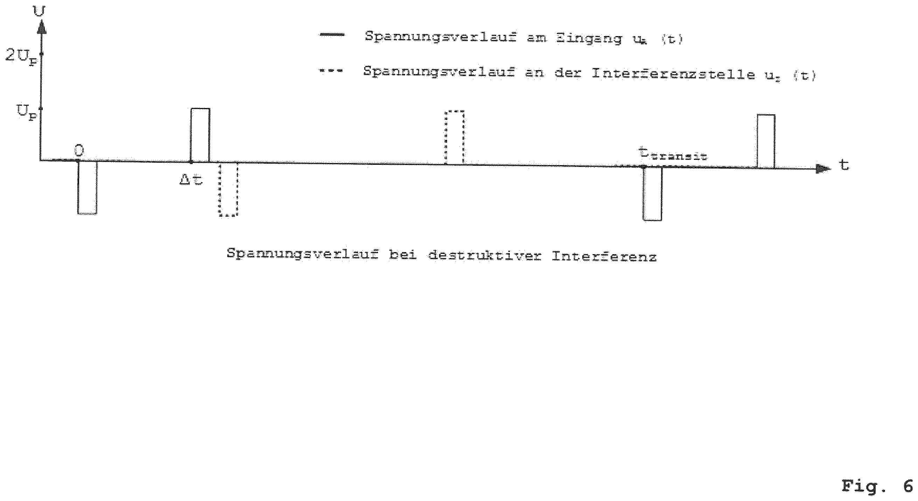

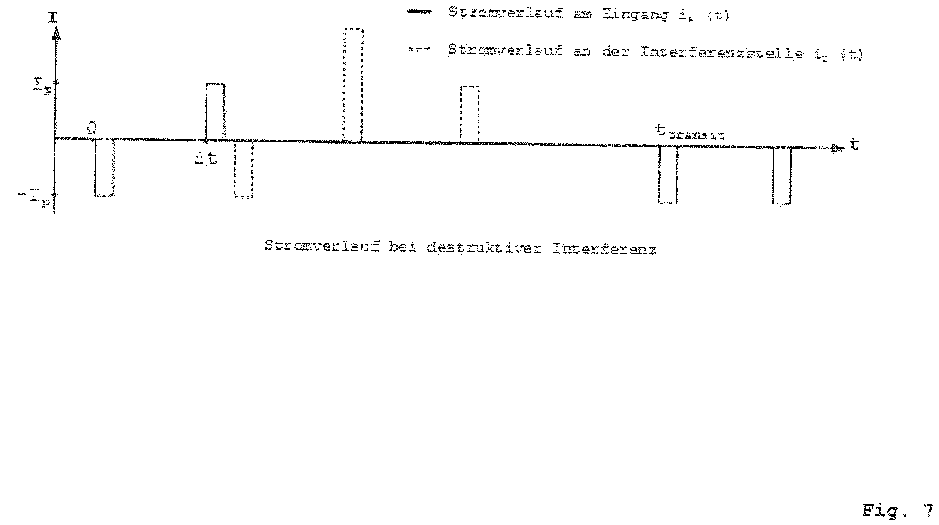

Beispielsweise kann durch die Erzeugung von jeweils konstruktiver und destruktiver Interferenz an einer konkreten, zu untersuchenden Stelle x des zu diagnostizierenden Betriebsmittels die Genauigkeit der Auswertung der lokalen Kenngrößen bzw. der Kriterien durch geeignete Algorithmen erheblich erhöht werden, wobei zwei Optionen zur Auswahl stehen:
Konstruktive Interferenz (vgl. insb. Fig. 4, 5) lässt sich z. B. durch Impulspaare mit jeweils gleicher Polarität der Spannung, gleicher Impulsbreite tW und einem definierten Abstand Δt erzeugen, wodurch an einer zu untersuchenden Stelle des Betriebsmittels eine Spannungsüberhöhung auftritt und sich somit lokal erhöhte dielektrische Verluste einstellen. Destruktive Interferenz (vgl. insb. Fig. 6, 7) lässt sich demgegenüber z. B. durch Impulspaare mit jeweils gleicher Impulsbreite tW und definiertem Impulsabstand Δt, aber mit jeweils unterschiedlicher Polarität der Spannung erzeugen, wodurch an einer zu untersuchenden Stelle des Betriebsmittels eine Spannungserniedrigung und damit einhergehend reduzierte dielektrische Verluste auftreten.

Ferner kann eine Ermittlung und Lokalisierung von starken Impedanz-Änderungen und Reflexionsstellen in dem Betriebsmittel mit Hilfe angepasster TDR bzw. FDR (z. B. Gauß-Impuls-Reversal, Kreuzkorrelation, Resonanzstellen, Frequenzspektrum) erfolgen. Ein Nichttreffen von Impulsen kann als zusätzliches Vergleichskriterium herangezogen werden, wobei der Impulsabstand so groß gewählt wird, dass keine Interferenz in dem Betriebsmittel auftritt (vgl. Fig. 3).

Darüber hinaus kann eine Gegensimulation mit einem neuwertigen, vergleichbaren (Referenz-)Betriebsmittel als ein Vergleichskriterium erfolgen. Die Simulationsgrundlage bildet ein Ersatzschaltbild für frequenzabhängige, räumlich ausgedehnte elektrische Betriebsmittel, diskretisiert in n (Einzel-)Elementen.

Ferner können im Rahmen einer weiter optimierten rechnerischen Auswertung eine Kombination verschiedener Kriterien, wie z. B. der Energieverlust für den Fall von konstruktiver, destruktiver Interferenz und/oder keiner Interferenz, sowie für ein homogenes bzw. inhomogenes, räumlich in seiner Längsrichtung ausgedehntes Betriebsmittel, weitergehende mathematische Kriterien und Korrelationen hieraus herangezogen werden.

Schließlich kann eine Berechnung der lokalen Energieverluste, der lokalen Kenngrößen und der lokalen Kriterien aus dem Zeitverlauf der gemessenen Spannung bzw. des Stromes (Methoden und Möglichkeiten der Berechnung, spezielle Integrationsverfahren, Fourier-Transformation usw.) erfolgen.

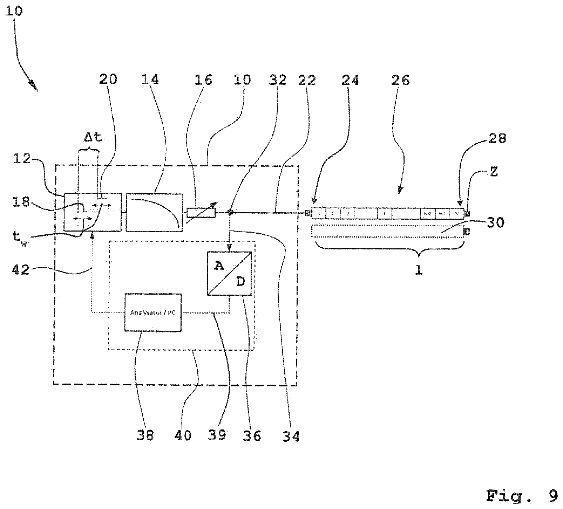

Eine mögliche Vorgehensweise soll im weiteren Fortgang der Beschreibung näher erläutert werden:
Man spaltet zunächst den Spannungsverlauf am Eingang (vgl. Fig. 9) in zwei Komponenten auf: Die eine ist der Spannungsverlauf ohne dessen Reflexionen und die andere ist nur der Spannungsverlauf mit den Reflexionen innerhalb des Betriebsmittels, Somit ergeben sich ein Spannungsverlauf Ue(t) und ein Spannungsverlauf Ur(t).

Im nächsten Verfahrensschritt wird von beiden Funktionen in bekannter Weise die "AKF" (AKF = Autokorrelationsfunktion) gebildet. Alle sich ergebenden Ordinatenwerte, die kleiner als ein definierter Schwellenwert sind, d. h. ein bestimmter prozentualer Anteil der ursprünglichen Amplitude, werden hierdurch zu Null gesetzt, um den vom Signalgenerator und Filtersystem verursachten Offset zu kompensieren. Anschließend wird die elektrische Verlustenergie wie folgt berechnet:

$$E_v = \int AKF(u_e(t))dt - \int AKF(u_r(t))dt \qquad (11)$$

Nach diesem Algorithmus wird die Verlustenergie für den Fall fehlender Interferenz in dem Betriebsmittel einmal und für jeden Interferenzpunkt (konstruktive bzw. destruktive Interferenz) berechnet. Somit ergibt sich dann als lokale Kenngröße im Fall konstruktiver Interferenz mit jeweils zwei positiven Impulsen die Energie nach der Beziehung

$$E_{W+}(x) = E_{V+}(x) - E_{VN+} \qquad (12)$$

und im Fall der destruktiven Interferenz mit jeweils abwechselnd negativen und positiven Impulsen die Energie gemäß der Gleichung:

$$E_{w-}(x) = E_{VN-} - E_{V-}(x) \qquad (13)$$

Darüber hinaus wird eine Vergleichssimulation mit einem homogenen, d. h. einem intakten Kabel durchgeführt und die Verlustenergie für diesen Fall berechnet. Setzt man nun die lokale Kenngröße der homogenen Leitung mit der der inhomogenen Leitung ins Verhältnis, so erhält man als ein lokales Kriterium eW(x).

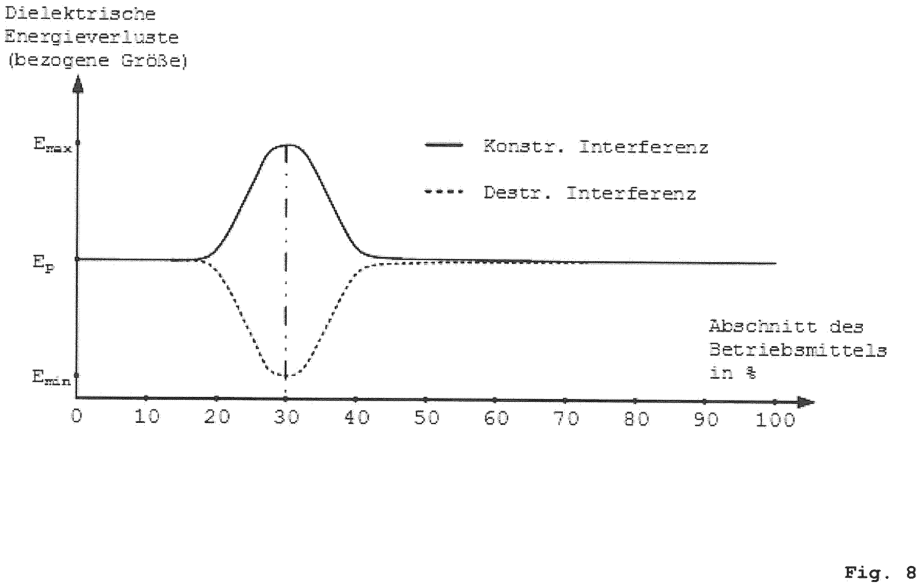

Fig. 8 zeigt ein Diagramm, in dem die dielektrischen Energieverluste über den Abschnitt eines zu untersuchenden Betriebsmittels, insbesondere eines Kabels zur Energieübertragung, in % abgetragen sind.

Bei ca. 30 % (x = 0,3, wenn Gesamtlänge l = 1,0 gesetzt) in Relation zu seiner (Gesamt-)Länge 1 weist das Betriebsmittel einen defekten Bereich mit signifikant verschlechterten dielektrischen Eigenschaften auf. Als ein exemplarisches Auswertekriterium zur Lokalisierung der Defektstelle wird der dielektrische Energieverlust (bezogene Größe) sowohl bei konstruktiver als auch im Fall destruktiver Interferenz der Impulse herangezogen.

Fig. 9 zeigt eine schematische Darstellung einer Vorrichtung zur Durchführung des erfindungsgemäßen, ortsaufgelösten Diagnoseverfahrens an einem ausgedehnten Betriebsmittel, insbesondere einem Kabel zur elektrischen Übertragung hoher elektrischer Energien.

Die Vorrichtung 10 umfasst unter anderem einen Impuls- bzw. einen Signalgenerator 12, dem ein Filtersystem 14 zur Bandbegrenzung des Eingangssignals sowie eine variable Impedanz 16 zur Anpassung an verschiedene Typen von Betriebsmitteln 26 bzw. Kabeln nachgeschaltet sind. Mittels des Impuls- bzw. des Signalgenerators 12 werden hier exemplarisch zwei gleichartige, beispielsweise rechteckförmige Impulse 18, 20 mit einem variablen Impulsabstand Δt erzeugt und über das Filtersystem 14 und die Impedanz 16 über ein Ankopplungsleitung 22 in einen Anfang 24 eines zu diagnostizierenden Betriebsmittels 26 eingespeist. Grundsätzlich können die Impulse 18, 20 einen beliebigen Spannungs- oder Stromverlauf über die Zeit t aufweisen. Jeweils zwei Impulse 18, 20 werden im Kontext dieser Beschreibung auch als ein Impulspaar bezeichnet. Das räumlich ausgedehnte Betriebsmittel 26, bei dem es sich bevorzugt um ein mehradriges Hochspannungskabel mit 3 Phasen, aber mindestens einer Ader zur elektrischen Energieübertragung oder dergleichen handelt, umfasst hier exemplarisch eine Vielzahl von 1 ... N Bereichen bzw. Kabelsegmenten oder Kabelabschnitten und weist eine Gesamtlänge 1 auf. An einem Ende 28 ist eine Impedanz Z vorgesehen, die als offenes Ende, als Kurzschluss oder als eine aktive Terminierung ausgeführt sein kann. Ferner kann an das Ankopplungsleitung 22 eine bevorzugt virtuelle, digital simulierte oder eine reale Nachbildung 30 des Betriebsmittels 26, wie mit einer punktierten Linie angedeutet, angeschlossen sein. An einer Abzweigung 32, bei der es sich z. B. um ein Koppelelement und/oder einen Koppler handelt, ist über eine (Mess)-leitung 34 eine Messeinrichtung 36, insbesondere ein Analog-Digital-Wandler mit einer hohen Abtastrate angeschlossen, der mit einer schnellen, bevorzugt einer digitalen Recheneinheit 38, wie z. B. einem PC, einem Digital-Oszilloskop, einem Analysator, einem Logik-Array verbunden ist. Die von dem Analog-Digital-Wandler ausgegebenen Digitalwerte der analogen Spannungen auf der Messleitung 34 gelangen über Datenleitungen 39 (Bus) an die Recheneinheit 38 zur Auswertung. Die Messeinrichtung 36 bildet hier zusammen mit der Recheneinheit 38 eine Auswerteeinheit 40.

Die Auswerteeinheit 40 kann weiterhin hier nicht dargestellte Ein- und Ausgabegeräte, wie z. B. Bildschirme, Projektoren, Tastaturen, akustische Signalgeber, Drucker etc. umfassen.

Mittels einer weiteren Leitung 42 erfolgt die Ansteuerung bzw. die Triggerung des Impulsgenerators vorzugsweise ausgehend von den Ergebnissen der Signalverarbeitung innerhalb der Recheneinheit 38. Die Impulsbreite tW bzw. die zeitliche Länge der Impulse 18, 20 ist gleichfalls variabel, wobei diese bevorzugt jeweils gleich ist.

Mittels der Auswerteeinheit 40 lässt sich der Spannungsverlauf am Anfang 24 des nach Art eines Kabels ausgebildeten Betriebsmittels 26 messen und auswerten. Zugleich wird der Impulsabstand Δt bevorzugt in Abhängigkeit von den Ergebnissen der Auswertung variiert, so dass alle Segmente 1 ... N des Betriebsmittels 26 einer hochpräzisen, ortsaufgelösten dielektrischen Diagnose unterzogen werden können. Hierdurch können ggfls. defekte Bereiche 1 ... N sicher erkannt und unter Umständen deren Restlebensdauer prognostiziert werden, so dass ein sofortiger Austausch des betroffenen Kabelsegments geplant werden kann.

Alternativ können die Impulse auch an dem Anfang 24 und/oder an dem Ende 28 des Betriebsmittels 26 eingespeist werden. Weiterhin können die Impulse 18, 20 einen von der in Fig. 9 lediglich exemplarisch dargestellten Rechteckform abweichenden Verlauf aufweisen und z. B. einen dreieckförmigen, einen sägezahnförmigen, einen trapezförmigen, einen sinusförmigen, einen exponentiellen, einen glockenförmigen (d. h. Gaußförmigen) Verlauf oder eine Kombination von mindestens zwei der genannten Geometrien aufweisen.

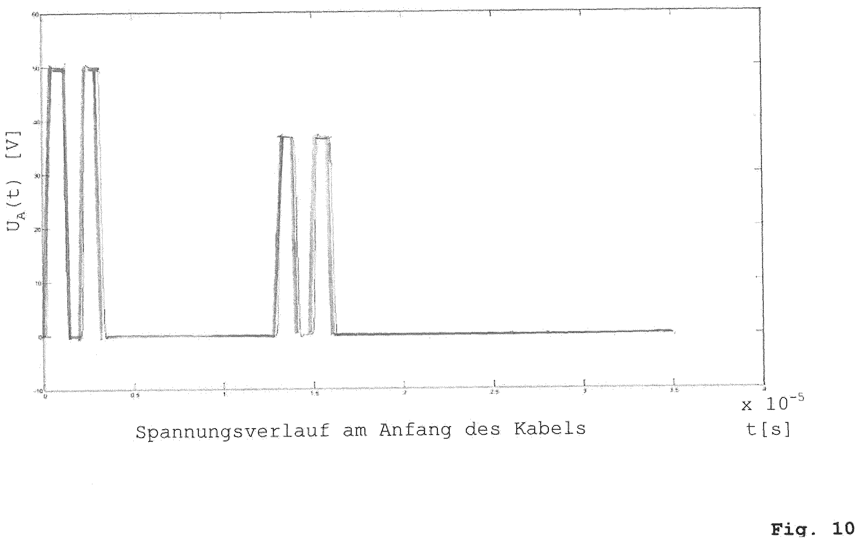

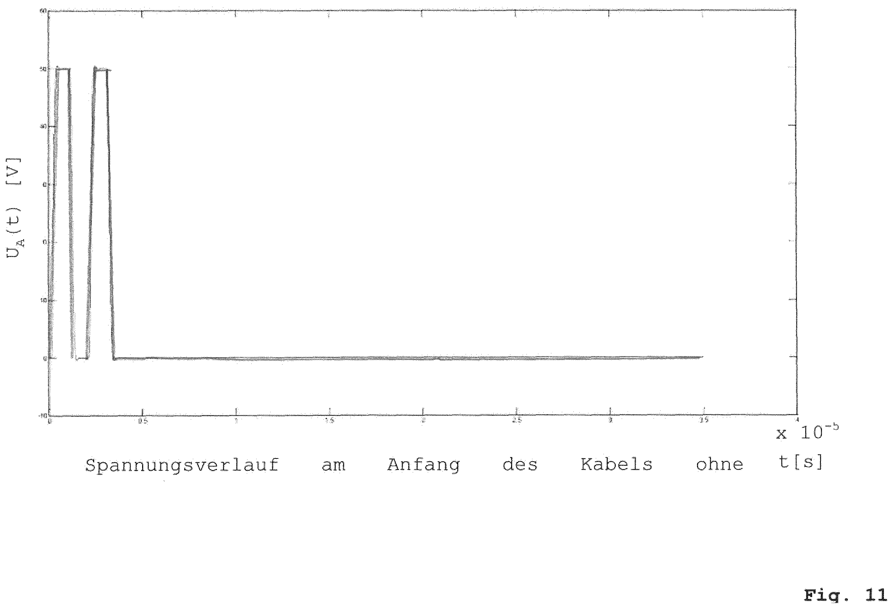

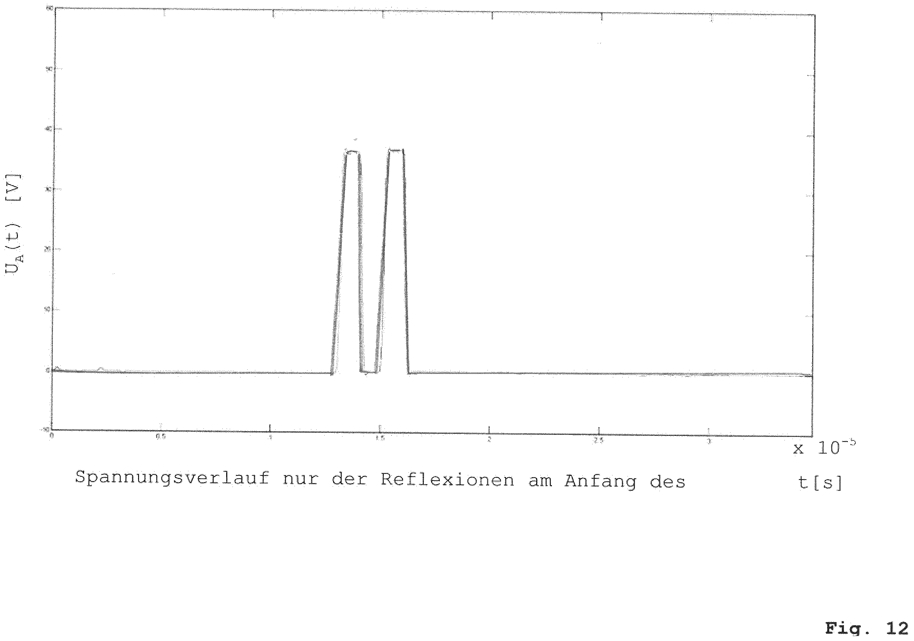

Die Fig. 10 zeigt den innerhalb der erfindungsgemäßen (Mess-)Vorrichtung von Fig. 9 auftretenden Spannungsverlauf UA(t) am Anfang 24 des Betriebsmittels 26, der eine Superposition von Fig. 11 mit dem Spanungsverlauf UA(t) am Anfang 24 des Betriebsmittels 26 ohne Reflexionen und von Fig. 12 mit dem ausschließlich die Reflexionen enthaltenden Spannungsverlauf UA(t) am Anfang 24 des Betriebsmittels 26 darstellt.

Durch die Erfindung eröffnet sich erstmals die Möglichkeit, den Zustand einzelner Segmente bzw. Abschnitte eines zu untersuchenden Betriebsmittels, insbesondere eines Hochspannungskabels zur elektrischen Energieübertragung, zu evaluieren und diese in einem Fehlerfall gezielt austauschen bzw. ihren Ausfall prognostizieren zu können. Somit ergeben sich z. B. für Energieversorger vollkommen neue Möglichkeiten bei der präventiven Kabeldiagnose und dem Asset-Management. Durch geeignete zustands- und risikobasierte Strategien entsteht ein beträchtliches Einsparpotential bei der Wartung und der Instandhaltung von Kabeltrassen. Mit Hilfe des erfindungsgemäßen Verfahrens lassen sich darüber hinaus heterogene Kabeltrassen, wie z. B. Mischstrecken aus Papiermasse- und VPEisolierten Kabeln, präzise messtechnisch erfassen und diagnostizieren. Es können deren Aufbau und die Positionen der Kabelmuffen mit hoher Genauigkeit bestimmt werden.

Darüber hinaus handelt es sich um ein zerstörungsfreies sowie belastungsarmes Messverfahren, wodurch eine Verschlechterung des elektrischen Zustands des Kabels aufgrund hoher Spannungs- bzw. Strombelastungen während der Messung weitestgehend vermieden wird.

Die elektrische Zustandsdiagnose ist in Abhängigkeit vom Ort x entlang der Längserstreckung des Betriebsmittels möglich (s. g. Ortsauflösung). Hierdurch können einzelne Kabelsegmente bzw. Kabelabschnitte metergenau hinsichtlich ihrer dielektrischen Eigenschaften evaluiert werden. Die Vorrichtung erlaubt unter anderem auch eine Messung am Ende des Betriebsmittels, so dass keine Synchronisation zwischen dem Anfang und dem Ende des Betriebsmittels notwendig ist. Vielmehr ist lediglich eine Synchronisation zwischen dem Impuls- bzw. dem Signalgenerator und der Messsignalerfassung vonnöten.

Die Hardware zur Signalerzeugung, Messung und Steuerung verfügt über einen kompakten Aufbau und ermöglicht im Gegensatz zu konventionellen Messverfahren und Messaufbauten einen problemlosen Einsatz vor Ort im Feld, was einen klaren Vorteil gegenüber dem Stand der Technik darstellt.

Schließlich ist bei einer Kombination des erfindungsgemäßen Verfahrens mit anderen Diagnosemethoden eine hochpräzise Ermittlung aller relevanten Leitungsparameter eines Betriebsmittels in jedem differentiellen Teilsegment bzw. in jedem Abschnitt möglich.

Bezugszeichenliste

| 10. | Vorrichtung | | |
|---|---|---|---|
| 12. | Signal- bzw. Impulsgenerator | | |
| 14. | Filtersystem | | |
| 16. | variable Impedanz | | |
| 18. | Impuls | | |
| 20. | Impuls | | |
| 22. | Ankopplungsleitung | | |
| 24. | Anfang (Betriebsmittel) | | |
| 26. | Betriebsmittel (Kabel) | | |
| 28. | Ende (Betriebsmittel) | | |
| 30. | Nachbildung (Leitung) | | |
| 32. | Abzweigung | | |
| 34. | Leitung (Messleitung) | | |
| 36. | Messeinrichtung | | |
| 38. | Recheneinheit | | |
| 39. | Datenleitungen (Bus) | | |

(fortgesetzt)

| | | | |
|---|---|---|---|
| 40. | Auswerteeinheit | | |
| 42. | Leitung (Triggerleitung) | | |
| 44. | Impulsbreite (tW) | | |
| 46. | Impulsbreite (tW) | | |
| | | | |
| | | | |
| | | | |
| | | | |
| Z | Impedanz | | |
| $\Delta$t | Impulsabstand | | |
| tW | Impulsbreite | | |
| | | | |
| | | | |
| | | | |

## Patentansprüche

1.  Verfahren zur ortsaufgelösten Diagnose des elektrischen Zustands eines räumlich ausgedehnten Betriebsmittels (26), insbesondere eines Kabels zur Übertragung elektrischer Energie, mit Hilfe von Interferenz zwischen in das Betriebsmittel (26) durch einen Signalgenerator (12) eingespeisten Impulsen (18, 20). Hierbei sind grundsätzlich folgende Verfahrensschritte vorgesehen:

    a) Einspeisen von mindestens zwei um einen Impulsabstand $\Delta$t versetzten Impulsen (18, 20) in das Betriebsmittel (26),
    b) Erfassen der interferierten Impulse (18, 20) und Echos mittels einer Auswerteeinheit (40),
    c) Variation des Impulsabstandes $\Delta$t zur ortsaufgelösten Abtastung des Betriebsmittels (26) entlang dessen Länge I,
    d) Wiederholen der Schritte a) bis c) bis das Betriebsmittel (26) zumindest abschnittsweise abgetastet ist, und
    e) Auswerten der erfassten interferierten Impulse (18, 20) in der Auswerteeinheit.

2.  Verfahren nach Anspruch 1, **dadurch gekennzeichnet, dass** im Verfahrensschritt e) zur ortsaufgelösten Diagnose lokale Energieverluste eW(x) über die Länge I des Betriebsmittels (26) hinweg anhand einer Vielzahl von durch die Impulse (18, 20) hervorgerufenen Interferenzspannungsverläufen und Spannungsverläufen rechnerisch ermittelt werden, wobei die Spannungsverläufe mittels der Auswerteeinheit (40) digitalisiert und rechnerisch zu einer fehlerfreien Nachbildung (30) des Betriebsmittels (26) in Beziehung gesetzt werden.

3.  Verfahren nach einem der Ansprüche 1 oder 2, **dadurch gekennzeichnet, dass** jeweils zwei Impulse (18, 20) gleicher oder gegensätzlicher Polarität konstruktiv oder destruktiv miteinander interferieren.

4.  Verfahren nach einem der Ansprüche 1 bis 3, **dadurch gekennzeichnet, dass** Impulse und Impulsfolgen mit einer Maximalamplitude von bis zu 1.000 Volt erzeugt werden.

5.  Verfahren nach einem der Ansprüche 1 bis 4, **dadurch gekennzeichnet, dass** die Länge I des Betriebsmittels (26) mittels der Auswerteeinheit (40) und des Signalgenerators (12), insbesondere mit Hilfe einer Laufzeitmessung mindestens eines Impulses (18, 20), erfasst wird.

6.  Verfahren nach einem der Ansprüche 1 bis 5, **dadurch gekennzeichnet, dass** die ortsaufgelöste Diagnose des elektrischen Zustands des Betriebsmittels (26) vollautomatisch unter bevorzugter Kontrolle der Auswerteeinheit und/oder manuell erfolgt.

7. Vorrichtung (10) zur ortsaufgelösten Diagnose eines elektrischen Zustands eines räumlich ausgedehnten Betriebsmittels (26), insbesondere eines Kabels zur Übertragung elektrischer Energie, mit Hilfe von Interferenz zwischen mindestens zwei um einen variablen Impulsabstand Δt zeitlich versetzt in das Betriebsmittel (26) eingespeisten Impulsen (18, 20), **dadurch gekennzeichnet, dass** mindestens ein Signalgenerator (12) zur Erzeugung der Impulse (18, 20) mit dem Betriebsmittel (26) und mit einer Auswerteeinheit (40) verbunden ist, wobei zur ortsaufgelösten Diagnose lokale Energieverluste eW(x) über die Länge l des Betriebsmittels (26) hinweg anhand einer Vielzahl von durch die Impulse (18, 20) hervorgerufenen Interferenzspannungsverläufen und Spannungsverläufen rechnerisch ermittelbar sind.

8. Vorrichtung nach Anspruch 7, **dadurch gekennzeichnet, dass** die Spannungsverläufe mittels der Auswerteeinheit (40) digitalisierbar und rechnerisch zu einer fehlerfreien Nachbildung (30) des Betriebsmittels (26) in Beziehung setzbar sind.

9. Vorrichtung (10) nach Anspruch 7 oder 8, **dadurch gekennzeichnet, dass** dem Signalgenerator (12) ein Filtersystem (14) und eine variable Impedanz (16) nachgeschaltet sind, wobei die anpassbare Impedanz (16) mit einem Anfang (24) des Betriebsmittels (26) verbunden ist.

10. Vorrichtung (10) nach einem der Ansprüche 7 bis 9, **dadurch gekennzeichnet, dass** der Auswerteeinheit (40) eine Messeinrichtung (36), insbesondere ein Analog-Digitalwandler und mindestens eine digitale Recheneinheit (38), zugeordnet ist.

11. Vorrichtung (10) nach einem der Ansprüche 7 bis 10, **dadurch gekennzeichnet, dass** ein Ende (28) des Betriebsmittels (26) offen ist oder mit einer Impedanz Z abgeschlossen ist.

12. Vorrichtung (10) nach Anspruch 11, **dadurch gekennzeichnet, dass** die fehlerfreie Nachbildung (30) des Betriebsmittels (26) mit dem Signalgenerator (12) und der Auswerteeinheit (40) koppelbar ist.

13. Vorrichtung (10) nach einem der vorangehenden Ansprüche, **dadurch gekennzeichnet, dass** mittels des Signalgenerators (12) Impulse (18, 20) gleicher Polarität oder Impulse (18, 20) mit gegensätzlicher Polarität erzeugbar sind.

14. Vorrichtung (10) nach einem der vorangehenden Ansprüche, **dadurch gekennzeichnet, dass** eine Länge l des Betriebsmittels (26) mittels der Auswerteeinheit (40) und dem Signalgenerator (12), insbesondere mit Hilfe einer Laufzeitmessung mit mindestens einem Impuls (18, 20), erfassbar ist.

## Claims

1. A method for the spatially resolved diagnosis of the electrical state of a spatially extended operating means (26), in particular a cable for the transmission of electrical energy, with the help of interference between pulses (18, 20) fed to the operating means (26) by a signal generator (12). The following method steps are provided in this case in principle:

   a) feeding of at least two pulses (18, 20) offset by a pulse interval Δt to the operating means (26),
   b) detection of the interfering pulses (18, 20) and echoes by means of an evaluation unit (40),
   c) variation of the pulse interval Δt for spatially resolved scanning of the operating means (26) along the length 1 thereof,
   d) repetition of steps a) to c) until the operating means (26) is scanned at least in sections and
   e) evaluation of the interfering pulses (18, 20) in the evaluation unit.

2. The method according to claim 1, **characterized in that** in method step e) local energy losses eW(x) are computed over the length 1 of the operating means (26) for the spatially resolved diagnosis with the help of a plurality of interference voltage waveforms and voltage waveforms generated by the pulses (18, 20), wherein the voltage waveforms are digitized by means of the evaluation unit (40) and correlated computationally into a fault-free simulation (30) of the operating means (26).

3. The method according to any one of claims 1 or 2, **characterized in that** two pulses (18, 20) with the same or opposite polarity in each case interfere with one another constructively or destructively.

4. The method according to one of claims 1 to 3, **characterized in that** pulses and pulse trains with a maximum amplitude of up to 1000 volts are produced.

5. The method according to one of claims 1 to 4, **characterized in that** the length 1 of the operating means (26) is detected by means of the evaluation unit (40) and the signal generator (12), in particular by means of a travel-time measurement of at least one pulse (18, 20).

6. The method according to one of claims 1 to 5, **characterized in that** the spatially-resolved diagnosis of the electrical state of the operating means (26) is carried out fully automatically with preferred control of the evaluation unit and/or manually.

7. A device (10) for the spatially resolved diagnosis of an electrical state of a spatially extended operating means (26), in particular a cable for the transmission of electrical energy, with the help of interference between at least two pulses (18, 20) offset in time by a variable pulse interval Δt in the operating means (26), **characterized in that** at least one signal generator (12) for producing the pulses (18, 20) is connected to the operating means (26) and to an evaluation unit (40), wherein for locally resolved diagnosis local energy losses eW(x) over the length 1 of the operating means (26) can be computationally determined with the help of a variety of interference voltage waveforms and voltage waveforms generated by the pulses (18, 20).

8. The device according to claim 7, **characterized in that** the voltage waveforms can be digitized by means of the evaluation unit (40) and correlated computationally into a fault-free simulation (30) of the operating means (26).

9. The device (10) according to claim 7 or 8, characterized a filter system (14) and a variable impedance (16) are connected to the signal generator (12) downstream, wherein the adjustable impedance (16) is connected to a top (24) of the operating means (26) .

10. The device (10) according to one of claims 7 to 9, **characterized in that** the evaluation unit (40) is assigned a measuring device (36), in particular an analogue-digital converter, and at least one digital computing unit (38).

11. The device (10) according to one of claims 7 to 10, **characterized in that** one end (28) of the operating means (26) is open or is terminated with an impedance Z.

12. The device (10) according to claim 11, **characterized in that** the fault-free simulation (30) of the operating means (26) can be coupled with the signal generator (12) and the evaluation unit (40).

13. The device (10) according to one of the preceding claims, **characterized in that** by means of the signal generator (12) pulses (18, 20) with the same polarity or pulses (18, 20) with opposite polarity can be generated.

14. The device (10) according to one of the preceding claims, **characterized in that** a length 1 of the operating means (26) can be detected by means of the evaluation unit (40) and the signal generator (12), in particular with the help of a travel-time measurement with at least one pulse (18, 20).

**Revendications**

1. Procédé de diagnostic à résolution spatiale de l'état électrique d'un équipement étendu spatialement (26), notamment d'un câble pour la transmission d'énergie électrique, à l'aide d'une interférence entre les impulsions (18,20) alimentées dans l'équipement (26) par l'intermédiaire d'un générateur de signaux (12), dans ce cadre les étapes de procédé fondamentales suivantes sont prévues :

   a) alimenter au moins deux impulsions (18,20) décalées d'un intervalle d'impulsion Δt dans l'équipement (26),
   b) détecter les impulsions interférentes (18,20) et les échos au moyen d'une unité d'évaluation (40),
   c) varier l'intervalle d'impulsion Δt par rapport au balayage à résolution spatiale de l'équipement (26) le long de sa longueur l,
   d) répéter les étapes a) à c) jusqu'à ce que l'équipement (26) soit balayé au moins par portions, et
   e) évaluer les impulsions interférentes (18,2120) détectées dans l'unité d'évaluation.

2. Procédé selon la revendication 1, **caractérisé en ce que** à l'étape de procédé e) à des fins de diagnostic à résolution spatiale des pertes d'énergie locale eW(x) sont déterminées arithmétiquement sur la longueur I de l'équipement (26) sur la base d'une pluralité de courbes de tension et de courbes de tension d'interférence provoquées par les impulsions, dans lequel les courbes de tension sont associées de manière numérisée et arithmétique au moyen de l'unité d'évaluation (40) à une reproduction exempte d'erreurs (30) de l'équipement (26).

3. Procédé selon une des revendications 1 ou 2, **caractérisé en ce que** respectivement deux impulsions (18, 20) de polarités identiques ou opposées interfèrent l'une avec l'autre de manière constructive ou destructive.

4. Procédé selon une des revendications 1 à 3, **caractérisé en ce que** les impulsions et les séquences d'impulsions sont générées avec une amplitude maximale allant jusqu'à 1000 V.

5. Procédé selon une des revendications 1 à 4, **caractérisé en ce que** la longueur 1 de l'équipement (26) est détecté eau moyen de l'unité d'évaluation (40) et du générateur de signaux (12), notamment à l'aide d'une mesure de temps de propagation d'au moins une impulsion (18,20).

6. Procédé selon une des revendications 1 à 5, **caractérisé en ce que** le diagnostic à résolution spatiale de l'état électrique de l'équipement (26) est effectué manuellement et/ou de manière totalement automatisée sous le contrôle préféré de l'unité d'évaluation.

7. Dispositif (10) de diagnostic par une résolution spatiale d'un état électrique d'un équipement étendu spatialement (26), notamment un câble pour la transmission d'énergie électrique, à l'aide d'une interférence entre les impulsions (18,20) alimentées dans l'équipement (26) décalées temporellement d'un intervalle d'impulsions Δt variable, **caractérisée en ce que** au moins un générateur de signaux (12) pour la génération des impulsions (18,20) est relié avec l'équipement (26) et avec une unité d'évaluation (40), dans lequel à des fins de diagnostic par résolution spatiale des pertes d'énergie locale eW(x) sur la longueur 1 de l'équipement (26) peuvent être déterminées arithmétiquement sur la base d'une pluralité de courbes de tension et de courbes de tension d'interférence provoquée par les impulsions (18, 20).

8. Dispositif selon la revendication 7, **caractérisé en ce que** les courbes de tension peuvent être numérisées au moyen de l'unité d'évaluation (40) et peuvent être associées arithmétiquement à une reproduction exempte d'erreurs (30) de l'équipement (26).

9. Dispositif (10) selon la revendication 7 ou 8, **caractérisé en ce que** en aval du générateur de signaux (12) sont branchés un système de filtre (14) et une impédance variable (16), dans lequel l'impédance adaptable (16) est reliée avec un début (24) de l'équipement (26).

10. Dispositif (10) selon une des revendications 7 à 9, **caractérisé en ce que** l'unité d'évaluation (40) est coordonnée à un dispositif de mesure (36), notamment à un convertisseur analogique-numérique et au moins une unité informatique numérique (38).

11. Dispositif (10) selon une des revendications 7 à 10, **caractérisé en ce que** une extrémité (28) de l'équipement (26) est ouverte ou est isolée avec une impédance Z.

12. Dispositif (10) selon la revendication 11, **caractérisé en ce que** la reproduction exempte d'erreurs (30) de l'équipement (26) peut être reliée avec le générateur de signaux (12) et l'unité d'évaluation (40).

13. Dispositif (10) selon une des revendications précédentes, **caractérisé en ce que** au moyen du générateur de signaux (12), des impulsions de polarités identiques (18,20) ou des impulsions avec une polarité opposée (18,20) peuvent être générées.

14. Dispositif (10) selon une des revendications précédentes, **caractérisé en ce que** une longueur I de l'équipement (26) peut être détectée au moyen de l'unité d'évaluation (40) et du générateur de signaux (12), notamment à l'aide d'une mesure de temps de propagation avec au moins une impulsion (18,20).

Fig. 1

Fig. 2

Fig. 3

Spannungsverlauf bei konstruktiver Interferenz

Fig. 4

Stromverlauf bei konstruktiver Interferenz

Fig. 5

EP 2 930 522 B1

Spannungsverlauf bei destruktiver Interferenz

EP 2 930 522 B1

Fig. 6

Stromverlauf bei destruktiver Interferenz

Fig. 7

EP 2 930 522 B1

Fig. 8

Fig. 9

Spannungsverlauf am Anfang des Kabels

Fig. 10

Spannungsverlauf am Anfang des Kabels ohne

**Fig. 11**

EP 2 930 522 B1

Spannungsverlauf nur der Reflexionen am Anfang des

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010013103 A1
- JP 2001153913 A
- US 7966137 B2
- US 20060097730 A1
- US 20080048668 A1

**In der Beschreibung aufgeführte Nicht-Patentliteratur**

- Network Cable Fault Location Based on the Wide Pulse Time Domain Reflection. **KE LIU ; SHULIN TIAN ; YINDONG XIAO ; DI XIE.** Testing and Diagnosis. IEEE Circuits and Systems International Conference ON, 28. April 2009, 1-3